# EUROPEAN PATENT SPECIFICATION

(11) **EP 2 860 235 B1**
(45) Date of publication and mention of the grant of the patent: **06.09.2017**
(21) Application number: 13801121.8
(22) Date of filing: 04.06.2013
(51) Int. Cl.: C09K 11/08, C09K 11/64, H01L 33/50, C09K 11/02, B05D 1/18, C09K 11/77, C30B 33/00, C30B 33/02

(54) **METHOD FOR TREATING SURFACE OF PHOSPHOR, PHOSPHOR, LIGHT-EMITTING DEVICE, AND ILLUMINATION DEVICE**
VERFAHREN ZUR OBERFLÄCHENBEHANDLUNG VON PHOSPHOR, PHOSPHOR, LICHTEMITTIERENDE VORRICHTUNG UND BELEUCHTUNGSVORRICHTUNG
PROCÉDÉ DE TRAITEMENT DE SURFACE DE LUMINOPHORE, LUMINOPHORE, DISPOSITIF ÉMETTANT DE LA LUMIÈRE ET DISPOSITIF D'ÉCLAIRAGE

(30) Priority: 08.06.2012 JP 2012130333
(43) Date of publication of application: 15.04.2015
(73) Proprietor: Denka Company Limited, Tokyo 103-8338 (JP)
(72) Inventor: TAKEDA, Go, Machida-city Tokyo 194-8560 (JP); NONOGAKI, Ryozo, Machida-city Tokyo 194-8560 (JP)
(74) Representative: Müller-Boré & Partner Patentanwälte PartG mbB
(86) International application number: PCT/JP2013/065443
(87) International publication number: WO 2013/183620

(56) References cited:
- JP-A- H01 315 485
- JP-A- H08 319 483
- JP-A- S63 199 787
- JP-A- 2001 089 761
- JP-A- 2002 309 247
- JP-A- 2006 269 938
- US-A1- 2003 034 481
- US-A1- 2009 072 255
- US-A1- 2009 243 467
- US-B1- 6 303 051

## Description

### Technical Field

The present invention relates to a method for treating the surface of a phosphor, a phosphor treated by the method, a light-emitting device and an illumination device using the phosphor. More specifically, it relates to a method for treating the surface of a Sr-containing nitride phosphor of which the host crystal has a crystal structure substantially identical with that of (Sr,Ca)AlSiN₃ crystal.

### Background Art

Sr-containing nitride phosphors are vulnerable to degradation by oxygen, heat, water, and others and thus have a problem particularly in moisture-resistance reliability. A possible reason for the fact that such a Sr-containing nitride phosphor is inferior in moisture-resistance reliability may be, for example, that the surface of the Sr-containing phosphor is readily hydrolyzed into a hydrolyzed layer containing Sr hydroxide for example in reaction with water in the atmosphere or in the step in contact with water.

Known methods for improving the moisture resistance of phosphors include a method of treating the surface of the phosphor with a metal alkoxide or the derivative thereof (see Patent Document 1) and a method of forming a fluorine-containing surface-finished layer on the surface of the phosphor (see Patent Document 2). Known methods for improving heat resistance include a method of treating a phosphor of a nitride-based fluorescent material with a phosphorus-containing compound (see Patent Document 3). A method for treating the surface of a phosphor, comprising an immersion step of immersing a phosphor in an aqueous ammonium-phosphate containing solution and a drying step is also known (see Patent Document 4).

### Citation List

### Patent Literatures

[Patent Document 1] JP-A No. 2008-111080
[Patent Document 2] JP-A No. 2012-31425
[Patent Document 3] JP-A No. 2006-269938
[Patent Document 4] US 2003 034481 A1

### Summary of Invention

### Technical Problem

However, the method of treating a phosphor with a metal alkoxide or the derivative thereof has a problem of aggregation of the phosphors. Alternatively, the method of forming a fluorine-containing surface-finished layer on the surface of a phosphor has a problem that the resin and the phosphor used in combination when the LED (Light Emitting Diode) is mounted are degraded by fluorine. Yet alternatively, the surface treatment method described in Patent Document 3 has a problem that, as a metal phosphate salt is used as the phosphorus-containing compound, the optical properties may be degraded for example by lanthanum contained therein.

Accordingly, a major object of the present invention is to provide a method for treating the surface of a (Sr,Ca)AlSiN₃ nitride phosphor that can improve the moisture-resistance reliability thereof without deterioration of optical properties, a phosphor prepared thereby and a light-emitting device and an illumination device using the same.

### Solution to Problem

The method for treating the surface of a Sr-containing nitride phosphor of which the host crystal has a crystal structure substantially identical with that of (Sr,Ca)AlSiN₃ crystal comprises an immersion step of immersing the phosphor in an aqueous ammonium phosphate-containing solution and a heat-treating step of leaving the phosphor after the immersion step in an environment at a temperature of 250 to 550°C for 2 to 24 hours.

In the method for treating the surface of a phosphor according to the present invention, a phosphorus content in the ammonium phosphate-containing solution is preferably 0.1 to 2.0 mass % with respect to the phosphor. The method for treating the surface of a phosphor according to the present invention preferably comprises additionally a washing step of washing the phosphor after the heat-treating step.

The phosphor according to the present invention is a Sr-containing nitride phosphor obtained by the surface treatment in an immersion step of immersing a Sr-nitride containing phosphor of which the host crystal has a crystal structure substantially identical with that of (Sr,Ca)AlSiN₃ crystal in an aqueous ammonium phosphate-containing solution and a heat-treating step of leaving the phosphor after the immersion step in an environment at a temperature of 250 to 550°C for 2 to 24 hours.

In production of the phosphor according to the present invention, the phosphorus content in the ammonium phosphate-containing solution used for the surface treatment is preferably 0.1 to 2.0 mass with respect to the phosphor. The surface treatment preferably comprises a washing step of washing the phosphor after the heat-treating step with water.

The phosphorus content of the phosphor according to the present invention is preferably 0.003 to 1 mass %.

The light-emitting device according to the present invention comprises the phosphor described above.

The illumination device according to the present invention comprises the light-emitting device.

### Advantageous Effects of Invention

It is possible according to the present invention to produce a phosphor improved in moisture-resistance reliability from conventional (Sr,Ca)AlSiN₃ nitride phosphors without deterioration in optical properties.

### Brief Description of Drawing

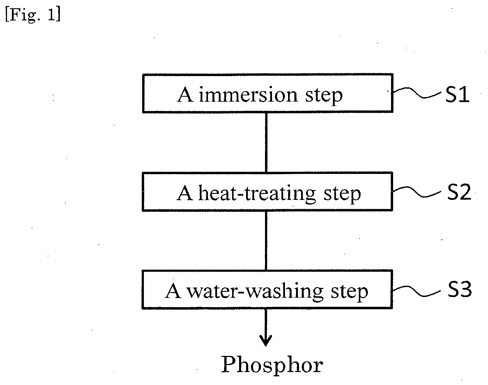

Figure 1 is a flowchart showing the method for treating the surface of a phosphor in an embodiment of the present invention.

### Description of Embodiments

Hereinafter, favorable embodiments of the invention will be described in detail.

Figure 1 is a flow chart showing the method for treating the surface of a phosphor according to an embodiment of the present invention. As shown in Figure 1, the method for treating the surface of a Sr-containing nitride phosphor of which the host crystal has a crystal structure substantially identical with that of (Sr,Ca)AlSiN₃ crystal in the present embodiment comprises an emmersion step of immersing the phosphor in an aqueous ammonium phosphate-containing solution (Step 1) and a heat-treating step of leaving the phosphor after the immersion step in an environment at a temperature of 250 to 550°C for 2 to 24 hours (Step 2). As shown in Figure 1, the method may comprise additionally a washing step (Step 3) of washing the phosphor after the heat-treating step, as needed.

### [Immersion step: Step 1]

Ammonium phosphate forms a Sr phosphate layer, which is less soluble in water, on the surface of the phosphor and the Sr phosphate layer functions as a barrier layer against water. As ammonium phosphate contains no metal element, there is no concern about the deterioration in optical properties of the phosphor, as in the surface treatment method described in Patent Document 3 above. The ammonium phosphate used in the immersion step is triammonium phosphate, diammonium hydrogen phosphate, ammonium dihydrogen phosphate, the mixture thereof or the hydrate thereof.

The ammonium phosphate used in the immersion step preferably has a phosphorus content of 0.1 to 2.0 mass %. It is thus possible to improve the moisture resistance further without deterioration in optical properties. Use of an ammonium phosphate having an excessively low phosphorus content may result in insufficient improvement of moisture resistance by the phosphorus treatment. Alternatively, use of an ammonium phosphate having an excessively high phosphorus content may result in thickening of the phosphorus-containing layer formed on the surface of the phosphor and thus lead to deterioration of phosphor fluorescence intensity by interference of light transmission.

The period of the phosphor being immersed in the aqueous ammonium phosphate-containing solution is preferably 30 minutes or more and 2 hours or less. It is because an excessively short period may lead to persistent presence of unreacted materials and an excessively long period may lead to not only saturation of the effectiveness of the immersion step but also deterioration of productivity. It is preferable to mix the aqueous ammonium phosphate-containing solution together with the phosphor in the immersion step and it is possible in this way to treat the surface of the phosphor more uniformly.

### [Heat-treating step: Step 2]

In the heat-treating step, the phosphor after the immersion step is heat-treated for vaporization of ammonia components on the surface, giving a less water-soluble Sr phosphate tightly formed on the phosphor surface. It is thus possible to improve the moisture-resistance reliability of the phosphor. However, when the heat treatment temperature is lower than 250°C or the storage period is shorter than 2 hours, there may be formed unreacted regions, prohibiting sufficient improvement of moisture resistance. On the other hand, when heat treatment temperature is higher than 550°C or the storage period is longer than 24 hours, the crystal structure of the phosphor changes, leading to deterioration of fluorescence characteristics. Accordingly, the heat treatment temperature is 250 to 550°C and the storage period is 2 to 24 hours.

The heat treatment temperature is preferably 300 to 500°C and it is thus possible to improve the moisture-resistance reliability further. The heat-treating step may be carried out under an inert gas, such as argon or nitrogen, or under air.

### [Water-washing step: Step 3]

There may be formed "surplus phosphorus-containing water-soluble compounds" remaining on the phosphor surface in the heat-treating step. The "surplus phosphorus-containing water-soluble compounds" may interfere light transmission in the phosphor, leading to deterioration of the fluorescence intensity thereof. It is thus preferable, in the method for treating the surface of a phosphor of the present embodiment, to carry out a water-washing step of removing the surplus phosphorus-containing water-soluble compounds present on the phosphor surface. It is possible in this way to reduce deterioration of optical properties further.

### [Phosphor after surface treatment]

The phosphor obtained by the method for treating the surface of a phosphor of the present embodiment preferably has a phosphorus content of 0.003 to 1 mass %. It is thus possible to improve the moisture-resistance reliability further and yet preserve favorable optical properties. An excessively low phosphorus content of the phosphor after surface treatment may lead to insufficient improvement of the moisture-resistance reliability while an excessively high phosphorus content of the phosphor after surface treatment to deterioration of the fluorescence properties. The phosphorus content of phosphor can be determined by inductively coupled plasma-atomic emission spectroscopy (ICP).

The moisture-resistance reliability of the phosphor obtained by the method for treating the surface of a phosphor of the present embodiment can be determined by conducting a moisture resistance test of storing the sample still for 1000 hours under an environment of a temperature of 85°C and a humidity of 85% and measuring the retention rate of fluorescence intensity. The retention rate of fluorescence intensity after 1000 hours is desirably 95% or more for reliable use of phosphor for an extended period of time.

As described above in detail, it is possible by the method for treating the surface of a phosphor of the present embodiment, wherein a phosphor is immersed in an aqueous ammonium phosphate-containing solution and then heat-treated under a particular condition, to improve the moisture-resistance reliability of the phosphor without deterioration of optical properties. It is possible by using the phosphor treated by the method above to obtain a light-emitting device and an illumination device higher in moisture-resistance reliability.

### Examples

Hereinafter, the advantageous effects of the present invention will be described with reference to Examples and Comparative Examples of the present invention and also to Table 1.

The phosphor treated by methods for treating the surface of a phosphor of Examples and Comparative Examples is that of a Sr-containing nitride phosphor of which the host crystal has a crystal structure substantially identical with that of (Sr,Ca)AlSiN₃ crystal and it is prepared by the production method below and shown in Reference Example 1 in Table 1.

### [Preparation of phosphor]

Raw materials used for preparation of the phosphor were α-silicon nitride powder (SN-E10 grade, produced by Ube Industries, Ltd.): 52.2 mass %, aluminum nitride powder (E grade, produced by Tokuyama Corp.): 45.8 mass %, and europium oxide (RU grade, produced by Shin-Etsu Chemical Co., Ltd): 2.0 mass %. These raw materials were mixed in a ball mill, to give a raw material mixture. During the ball mill mixing, a nylon pot and silicon nitride balls were used and ethanol was used as the solvent. The raw material mixture was dried for removal of the solvent and classified using a sieve having an opening of 75 µm. The powder obtained through the sieve was collected.

The raw material mixture after classification, strontium nitride powder (purity 99%, produced by Materion), and calcium nitride powder (purity 99%, produced by Materion) were placed in a glove box under nitrogen and mixed with a mortar therein, to give a raw powder mixture. The blending ratio of the raw material mixture after classification: strontium nitride: calcium nitride then was 49.5 mass %: 47.8 mass %: 2.7 mass %.

The raw powder mixture obtained was filled into a cylindrical container of boron nitride (N-1 grade, produced by Denki Kagaku Kogyo K.K.) equipped with a cap in the glove box. The container containing the filled raw powder mixture was removed from the glove box and placed rapidly in an electric furnace equipped with a carbon heater. The electric furnace was then deaerated sufficiently to an internal pressure of 0.1 Pa or less. The furnace was heated under the deaerated state and nitrogen gas was introduced at 600°C to an internal electric furnace pressure of 0.9 MPa. After introduction of nitrogen gas, the furnace was heated continuously to 1800°C and sintered at 1800°C for 4 hours, to give a phosphor.

The sintered phosphor was cooled and withdrawn from the electric furnace. The phosphor obtained was a reddish mass. It was milled in a ball mill and classified using a vibration sieve having an opening of 45 µm. The phosphor after classification that came out from the vibration sieve was then washed with water and fine powders floating on the water during washing were removed, to give a phosphor. The phosphor was analyzed on an X-ray diffractometer (Ultima IV, produced by Rigaku Corp.), showing that it was a phosphor of which the host crystal had a crystal structure substantially identical with that of (Sr,Ca)AlSiN₃ crystal.

### <Example 1>

The immersion step of immersing a phosphor of which the host crystal has a crystal structure substantially identical with that of (Sr,Ca)AlSiN₃ crystal in an aqueous ammonium phosphate-containing solution and the heat-treating step of keeping the phosphor after the immersion step in an environment at a temperature of 500°C for 2 hours were carried out, as described above, in the method for treating the surface of a phosphor of Example 1. In the immersion step, the phosphor prepared by the method described above and triammonium phosphate trihydrate (purity: 95% or more, produced by Kanto Chemical Co. Inc.) were suspended and stirred in pure water in the amount at a mass ratio of 7 times for 2 hours. The addition amount of triammonium phosphate trihydrate to the phosphor then was 2.80 mass % and the phosphorus content to the phosphor was 0.43 mass %.

In the heat-treating step, the phosphor after the immersion step was dried and collected; the collected phosphor was filled in an alumina crucible; the alumina crucible was placed in a muffle furnace and left there in air at a temperature of 500°C for 2 hours. After the heat-treating step, the muffle furnace was cooled to room temperature; the phosphor was classified using a 45-µm sieve, the phosphor that passed the sieve was collected and processed by the method for treating the surface of a phosphor of Example 1, to give a surface-treated phosphor.

Evaluation results of the phosphor obtained by the method for treating the surface of a phosphor of Example 1 described above are summarized in Table 1.

The "relative fluorescence intensity to Reference Example 1" in Table 1 was determined using the phosphor of Reference Example 1, rhodamine B, and a spectrofluorophotometer (F-7000, produced by Hitachi High-Technologies Corp.) that was previously calibrated with a substandard light source. A solid-sample holder of the photometer was used for measurement and the fluorescence spectrum at an excitation wavelength of 455 nm was determined. The "relative fluorescence intensity to Reference Example 1" indicated in Table 1 is a relative value of the peak intensity in the fluorescence spectrum relative to that (100%) of Reference Example 1. In the evaluation, a phosphor having a "relative fluorescence intensity to Reference Example 1" of 90% or more was considered satisfactory.

The "phosphor's relative peak intensity " in Table 1 is a value obtained by dividing the fluorescence intensity of the phosphor after moisture resistance test by the fluorescence intensity of the phosphor before moisture resistance test. The moisture resistance test was carried out under the environment of a temperature of 85°C, a humidity of 85%, and a period of 1000 hours. In evaluation, a phosphor having a "phosphor's relative peak intensity" of 90% or more was considered satisfactory.

The "phosphorus content in ammonium phosphate to phosphor (mass %)" in Table 1 is the content of phosphorus in the ammonium phosphate. The phosphor of Reference Example 1, which was not treated by the method for treating the surface of a phosphor, does not have the value.

The "ammonium phosphate content to phosphor (mass %)" in Table 1 is the content of ammonium phosphate with respect to the phosphor when the method for treating the surface of a phosphor is carried out. The phosphor of Reference Example 1, which was not treated by the method for treating the surface of a phosphor, does not have the value.

The "temperature of heat-treating step" in Table 1 is the temperature setting in the heat-treating step in the phosphor surface-treatment step. The "phosphorus content of phosphor after surface treatment" in Table 1 is a value obtained by inductively coupled plasma measurement (CIROS-120, produced by SPECTRO).

### <Example 2>

In the method for treating the surface of a phosphor of Example 2, the above-described phosphor of which the host crystal had a crystal structure substantially identical with that of (Sr,Ca)AlSiN₃ crystal was surface-treated in a manner and under conditions similar to Example 1, except that the temperature in the heat-treating step was changed to 300°C.

### <Example 3>

In the method for treating the surface of a phosphor of Example 3, the above-described phosphor of which the host crystal had a crystal structure substantially identical with that of (Sr,Ca)AlSiN₃ crystal was surface-treated in a manner and under conditions similar to Example 1, except that the addition amount of triammonium phosphate trihydrate to the phosphor was changed to 0.70 mass % (phosphorus content to phosphor was 0.11 mass %).

### <Example 4>

In the method for treating the surface of a phosphor of Example 4, a water washing step (Step 3) was added to the method for treating the surface of a phosphor of Example 3 described above. In the water washing step, the phosphor obtained in Example 3 was suspended in pure water in the amount at a mass ratio of 7 times, stirred therein for 2 hours, and washed with water and then dried.

### <Example 5>

In the method for treating the surface of a phosphor of Example 5, the above-described phosphor of which the host crystal had a crystal structure substantially identical with that of (Sr,Ca)AlSiN₃ crystal was surface-treated in a manner and under conditions similar to Example 1, except that the addition amount of triammonium phosphate trihydrate to phosphor in Example 1 was changed to 7.00 mass % (phosphorus content to phosphor was 1.10 mass %).

### <Comparative Example 1>

In the method for treating the surface of a phosphor of Comparative Example 1, the above-described phosphor of which the host crystal had a crystal structure substantially identical with that of (Sr,Ca)AlSiN₃ crystal was subjected only to the immersion step and the heat-treating step was eliminated.

### <Comparative Example 2>

In the method for treating the surface of a phosphor of Comparative Example 2, the above-described phosphor of which the host crystal had a crystal structure substantially identical with that of (Sr,Ca)AlSiN:₃ crystal was surface-treated in a manner and under conditions similar to Example 1, except that the temperature of the heat-treating step was set to 600°C.

The evaluation results of the phosphors of Examples 1 to 5, Reference Example 1, and Comparative Examples 1 and 2 are summarized in Table 1.

**[Table 1]**

| | Examples | | | | | Reference Example | Comparative Examples | |
|---|---|---|---|---|---|---|---|---|
| | 1 | 2 | 3 | 4 | 5 | 1 | 1 | 2 |
| Phosphorus content in ammonium phosphate to phosphor (mass %) | 0.43 | 0.43 | 0.11 | 0.11 | 1.07 | - | 0.43 | 0.43 |
| Ammonium phosphate content to phosphor (mass %) | 2.80 | 2.80 | 0.70 | 0.70 | 7.00 | - | 2.80 | 2.80 |
| Temperature of heat-treating step (°C) | 500 | 300 | 500 | 500 | 500 | - | - | 600 |
| Relative fluorescence intensity to Reference Example 1 (%) | 99 | 100 | 94 | 94 | 93 | 100 | 100 | 72 |
| Phosphorus content of phosphor after surface treatment (mass %) | 0.38 | 0.40 | 0.10 | 0.01 | 0.89 | 0.00 | 0.42 | 0.36 |
| Phosphor's relative peak intensity (%) | 100 | 99 | 95 | 94 | 93 | 78 | 79 | 70 |

As shown in Table 1, the phosphor of Example 1, which had a relative fluorescence intensity to Reference Example 1 of 99% and a phosphor's relative peak intensity of 100%, showed favorable results in fluorescence properties and moisture resistance, as determined by moisture resistance test. In addition, the phosphor after surface treatment had a phosphorus content of 0.38 mass %. The phosphor of Example 2 showed favorable results in fluorescence properties and moisture resistance, as determined in the moisture resistance test. The phosphor of Example 3 had a relative fluorescence intensity of 94% to Reference Example 1 and a phosphor's relative peak intensity, as determined by the moisture resistance test, of 95%.

As shown in Table 1, the phosphor of Example 4 had a phosphorus content of 0.01 mass %. The phosphor of Example 4 had a relative fluorescence intensity of 94% to Reference Example 1 and retained its fluorescence intensity of 94% even after the subsequent moisture resistance test. The results of Examples 3 and 4 indicate that the phosphorus content is preferably 0.1 mass % or more and the phosphorus content after surface treatment is preferably 0.003 mass % or more with respect to the phosphor.

As shown in Table 1, the phosphor of Example 5 had a phosphorus content of 0.89 mass %. It also had a relative fluorescence intensity of 93% to Reference Example 1 and retained its fluorescence intensity of 93% even after the subsequent moisture resistance test. The results indicate that the phosphorus content is preferably 2 mass % or less and the phosphorus content after surface treatment is preferably 1 mass % or less with respect to the phosphor.

The phosphor of Reference Example 1 had a phosphor's relative peak intensity of 78% and a light intensity decreased after the moisture resistance test. The phosphor of Comparative Example 1 had a relative fluorescence intensity of 100% to the Reference Example 1 after the surface-treatment step, but its phosphor's relative peak intensity was 79%. The phosphor of Comparative Example 2 had a relative fluorescence intensity of 72% to Reference Example 1, and its phosphor's relative peak intensity was 70%.

Although not shown in Table 1, in the method for treating the surface of a phosphor of Comparative Example 3, wherein the temperature in the heat-treating step of Example 1 was changed to 580°C, the phosphor had a relative fluorescence intensity of 76% and a phosphor's relative peak intensity of 73% to Reference Example 1. In the method for treating the surface of a phosphor of Comparative Example 4, wherein the temperature in the heat-treating step of Example 1 was changed to 620°C, the phosphor had a relative fluorescence intensity of 68% and a phosphor's relative peak intensity of 66% to Reference Example 1.

### <Example 6>

In Example 6, the phosphor of Example 1 described above was applied on the light-emitting face of a LED, as it is mixed with a silicone sealing resin, to give a light-emitting device. As the light-emitting device employed a phosphor superior in moisture-resistance reliability, it showed favorable long-term reliability.

### <Example 7>

In Example 7, an illumination device was prepared using the light-emitting device of Example 6 as light source. As the illumination device employed a phosphor superior in moisture-resistance reliability, it showed favorable long-term reliability.

## Claims

1. A method for treating the surface of an Sr-containing nitride phosphor of which the host crystal has a crystal structure identical with that of (Sr,Ca)AlSiN₃ crystal, comprising
an immersion step of immersing the phosphor in an aqueous ammonium phosphate-containing solution and
a heat-treating step of leaving the phosphor after the immersion step in an environment at a temperature of 250 to 550°C for 2 to 24 hours.

2. The method for treating the surface of an Sr-containing nitride phosphor according to Claim 1, wherein a phosphorus content in the ammonium phosphate-containing solution is 0.1 to 2.0 mass % with respect to the phosphor.

3. The method for treating the surface of an Sr-containing nitride phosphor according to Claim 1 or 2, additionally comprising a washing step of washing the phosphor after the heat-treating step with water.

4. An Sr-containing nitride phosphor of which the host crystal has a crystal structure identical with that of (Sr,Ca)AlSiN₃ crystal, which is surface-treated in an immersion step of immersing the phosphor in an aqueous ammonium phosphate-containing solution and a heat-treating step of leaving the phosphor after the immersion step in an environment at a temperature of 250 to 550°C for 2 to 24 hours.

5. The Sr-containing nitride phosphor according to Claim 4, wherein the ammonium phosphate-containing solution has a phosphorus content of 0.1 to 2.0 mass % with respect to the phosphor.

6. The Sr-containing nitride phosphor according to Claim 4 or 5, wherein the surface treatment additionally comprises a washing step of washing the phosphor after the heat-treating step with water.

7. The Sr-containing nitride phosphor according to any one of Claims 4 to 6, having a phosphorus content of 0.003 to 1 mass %.

8. A light-emitting device, comprising the Sr-containing nitride phosphor according to any one of Claims 4 to 7.

9. An illumination device, comprising the light-emitting device according to Claim 8.

## Patentansprüche

1. Verfahren zur Behandlung der Oberfläche eines Sr-haltigen Nitrid-Leuchtstoffs, dessen Wirtskristall eine Kristallstruktur, identisch zu der eines (Sr,Ca)AlSiN₃-Kristalls, aufweist, umfassend
einen Eintauchschritt des Eintauchens des Leuchtstoffs in eine wässrige ammoniumphosphathaltige Lösung und
einen Wärmebehandlungsschritt des Belassens des Leuchtstoffs nach dem Eintauchschritt in einer Umgebung bei einer Temperatur von 250 bis 550°C für 2 bis 24 Stunden.

2. Verfahren zur Behandlung der Oberfläche eines Sr-haltigen Nitrid-Leuchtstoffs nach Anspruch 1, wobei ein Phosphorgehalt in der ammoniumphosphathaltigen Lösung 0,1 bis 2,0 Massen%, bezogen auf den Leuchtstoff, beträgt.

3. Verfahren zur Behandlung der Oberfläche eines Sr-haltigen Nitrid-Leuchtstoffs nach Anspruch 1 oder 2, zusätzlich umfassend einen Waschschritt des Waschens des Leuchtstoffs nach dem Wärmebehandlungsschritt mit Wasser.

4. Sr-haltiger Nitrid-Leuchtstoff, dessen Wirtskristall eine Kristallstruktur, identisch zu der eines (Sr,Ca)AlSiN₃-Kristalls, aufweist, welcher oberflächenbehandelt ist in einem Eintauchschritt des Eintauchens des Leuchtstoffs in eine wässrige ammoniumphosphathaltige Lösung und einem Wärmebehandlungsschritt des Belassens des Leuchtstoffs nach dem Eintauchschritt in einer Umgebung bei einer Temperatur von 250 bis 550°C für 2 bis 24 Stunden.

5. Sr-haltiger Nitrid-Leuchtstoff nach Anspruch 4, wobei die ammoniumphosphathaltige Lösung einen Phosphorgehalt von 0,1 bis 2,0 Massen%, bezogen auf den Leuchtstoff, aufweist.

6. Sr-haltiger Nitrid-Leuchtstoff nach Anspruch 4 oder 5, wobei die Oberflächenbehandlung zusätzlich einen Waschschritt des Waschens des Leuchtstoffs nach dem Wärmebehandlungsschritt mit Wasser umfasst.

7. Sr-haltiger Nitrid-Leuchtstoff nach einem der Ansprüche 4 bis 6 mit einem Phosphorgehalt von 0,003 bis 1 Massen%.

8. Lichtemittierende Vorrichtung, umfassend den Sr-haltigen Nitrid-Leuchtstoff nach einem der Ansprüche 4 bis 7.

9. Beleuchtungsvorrichtung, umfassend die lichtemittierende Vorrichtung nach Anspruch 8.

## Revendications

1. Procédé de traitement de surface d'un nitrure de phosphore comprenant du Sr, dont le cristal de base a une structure cristalline identique à celle du cristal (Sr,Ca)AlSiN₃, comprenant
une étape d'immersion dans laquelle on immerge le phosphore dans une solution aqueuse comprenant du phosphate d'ammonium, et
une étape de traitement thermique dans laquelle on laisse le phosphore après l'étape d'immersion dans un environnement ayant une température allant de 250 à 550°C pendant 2 à 24 heures.

2. Procédé de traitement de surface d'un nitrure de phosphore comprenant du Sr selon la revendication 1, où la teneur en phosphore dans la solution aqueuse comprenant du phosphate d'ammonium se situe dans l'intervalle allant de 0,1 à 2,0% en masse par rapport au phosphore.

3. Procédé de traitement de surface d'un nitrure de phosphore comprenant du Sr selon la revendication 1 ou 2, comprenant en outre, une étape de lavage dans laquelle on lave le phosphore avec de l'eau après l'étape de traitement thermique.

4. Nitrure de phosphore comprenant du Sr, dont le cristal de base a une structure cristalline identique à celle du cristal (Sr,Ca)AlSiN₃, qui est traité en surface dans une étape d'immersion dans laquelle on immerge le phosphore dans une solution aqueuse comprenant du phosphate d'ammonium, et une étape de traitement thermique, dans laquelle on laisse le phosphore après l'étape d'immersion dans un environnement ayant une température allant de 250 à 550°C pendant 2 à 24 heures.

5. Nitrure de phosphore comprenant du Sr selon la revendication 4, où la solution comprenant du phosphate d'ammonium a une teneur en phosphore allant de 0,1 à 2,0% en masse par rapport au phosphore.

6. Nitrure de phosphore comprenant du Sr selon la revendication 4 ou 5, où le traitement de surface comprend en outre une étape de lavage dans laquelle on lave le phosphore avec de l'eau après l'étape de traitement thermique.

7. Nitrure de phosphore comprenant du Sr selon l'une quelconque des revendications 4 à 6, ayant une teneur en phosphore allant de 0,003 à 1% en masse.

8. Dispositif émettant de la lumière comprenant le nitrure de phosphore comprenant du Sr selon l'une quelconque des revendications 4 à 7.

9. Dispositif d'éclairement comprenant le dispositif émettant de la lumière selon la revendication 8.
